Europäisches Patentamt

European Patent Office

Office européen des brevets

(11) Numéro de publication: **0 432 047 A1**

## (12) DEMANDE DE BREVET EUROPEEN

(21) Numéro de dépôt: 90403473.3

(22) Date de dépôt: 06.12.90

(51) Int. Cl.5: **H01P 1/08**, H01J 23/40,
H01J 23/42

(30) Priorité: 08.12.89 FR 8916270

(43) Date de publication de la demande:
12.06.91 Bulletin 91/24

(84) Etats contractants désignés:
DE FR GB IT

(71) Demandeur: THOMSON TUBES
ELECTRONIQUES
38, rue Vauthier
F-92100 Boulogne-Billancourt(FR)

(72) Inventeur: Le Fur, Joel
Thomson-CSF, SCPI, Cedex 67
F-92045 Paris La Defense(FR)
Inventeur: Nugues, Pierre
Thomson-CSF, SCPI, Cedex 67
F-92045 Paris La Defense(FR)

(74) Mandataire: Guérin, Michel et al
THOMSON-CSF SCPI
F-92045 PARIS LA DEFENSE CEDEX 67(FR)

(54) **Fenêtre hyperfréquence à large bande de dimensions miniaturisées pour tubes électroniques.**

(57) La présente invention concerne une fenêtre hyperfréquence large bande de dimensions miniaturisées pour tubes électroniques, destinée particulièrement aux tubes à onde progressive à hélice. La fenêtre selon l'invention comporte une pièce plane diélectrique 20 brasée sur un support métallique 19 qui sera ensuite brasé sur la paroi de l'enceinte à vide du tube de façon à assurer l'étanchéité de l'ensemble ; l'adaptation large bande de la fenêtre étant assurée par une (ou deux) nervure(s) 22 faisant saillie(s) du support 19 vers l'intérieur de celui-ci, cette (ces) saillie(s) se trouvant, après brasage de la pièce diélectrique 20, plaquée(s) mais non brasée(s), contre la pastille.

FIG_3

## FENETRE HYPERFREQUENCE LARGE BANDE DE DIMENSIONS MINIATURISEES POUR TUBES ELECTRO-NIQUES

La présente invention concerne une fenêtre hyperfréquence large bande de dimensions miniaturisées pour tubes électroniques, ainsi que des tubes électroniques hyperfréquence comportant une telle fenêtre.

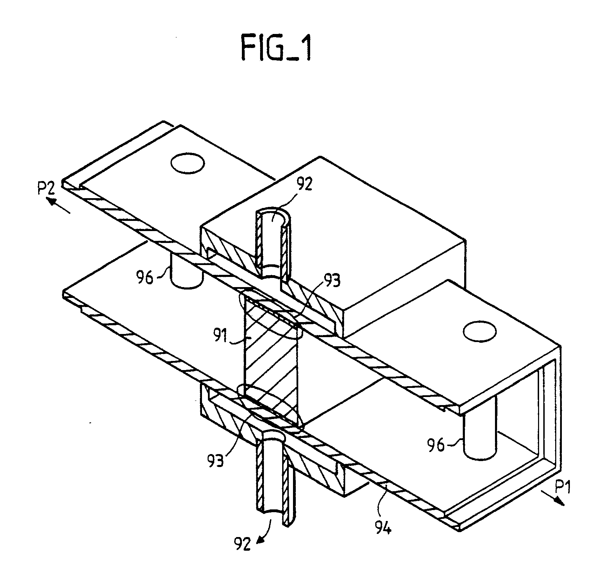

En effet, les tubes hyperfréquence qui fonctionnent avec un vide interne poussé, typiquement de l'ordre de $10^{-6}$ à $10^{-9}$ Torr, doivent être reliés aux circuits extérieurs d'utilisation (et, dans le cas des tubes amplificateurs, aux circuits d'introduction de signal hyperfréquence à amplifier) par des organes de liaison transparents à l'énergie hyperfréquence à la fréquence de fonctionnement ou dans la bande de fréquence utile, et étanches aux gaz pour permettre l'évacuation du tube et le maintien du vide à l'intérieur du tube. Lesdits organes de liaison peuvent comprendre, par exemple, un élément de couplage avec le circuit hyperfréquence du tube électronique ; une fenêtre hyperfréquence diélectrique souvent mais non exclusivement de la céramique ; des moyens d'adaptation pour supprimer des réflexions d'énergie hyperfréquence et des modes parasites de résonance dans la structure desdits organes de liaison ; et des moyens mécaniques permettant de rendre l'ensemble des organes de liaison solidaire au tube à vide, d'une part, et à raccorder avec le circuit extérieur d'utilisation à l'autre extrémité desdits organes de liaison. La figure 1 montre schématiquement en coupe longitudinale et en perspective une fenêtre hyperfréquence connue de l'art antérieur ; il s'agit d'une fenêtre rectangulaire de haute puissance et de bande relativement étroite, de l'ordre de quelques pour cent de la fréquence centrale de fonctionnement. Sur cette figure 1 on remarque une pièce plane diélectrique 91 rendue solidaire, de façon étanche, aux parois métalliques 94 par une brasure 93 sur le pourtour de la pièce diélectrique, ainsi que des moyens d'adaptation d'impédance 96 ; les flèches 92 indiquent le sens de circulation d'un liquide de refroidissement, et les repères P1 et P2 indiquent les pressions de chaque côté de la fenêtre, par exemple le vide à l'intérieur du tube et peut être 2 bars dans le circuit d'utilisation, respectivement.

De nombreuses variantes sont connues de l'homme du métier, car le compromis de différents paramètres peut être optimisé pour chaque utilisation envisagée.

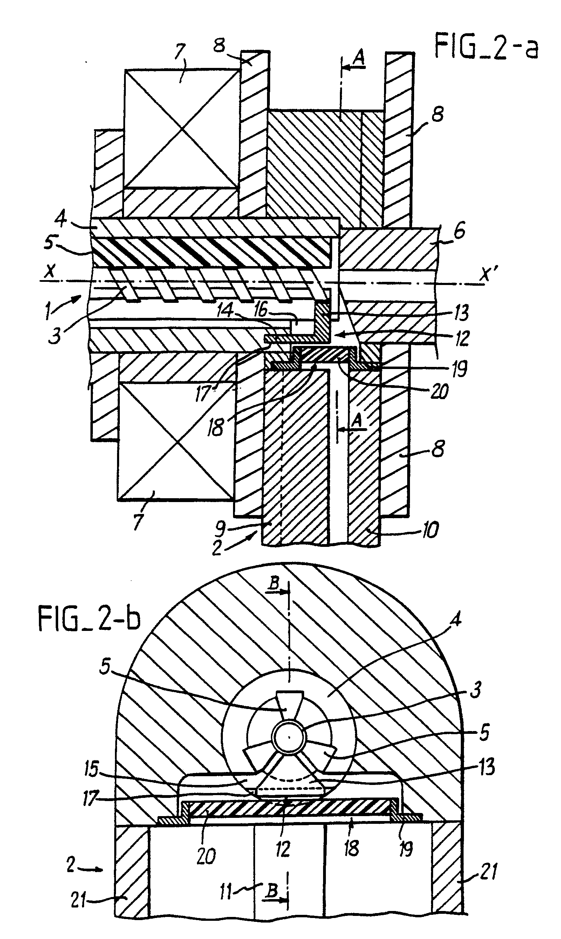

En particulier, la figure 2 montre schématiquement en coupe transversale partielle un tube à onde progressive à hélice muni d'une fenêtre conçue principalement pour réduire l'encombrement des organes de liaison pour obtenir certains avantages tels que décrits par la demanderesse dans la demande de brevet en France portant le numéro national F 88 13342 (11.10.1988).

Les dimensions de cette fenêtre sont considérablement réduites par rapport à des fenêtres plus classiques, ainsi que le volume interne de l'organe de liaison qui doit être évacué au niveau du vide poussé qui règne à l'intérieur du tube. Par contre la bande de fréquence d'utilisation est limitée par des réflexions de l'énergie au niveau de la fenêtre, car l'impédance dans le diélectrique n'est pas identique à l'impédance de part et d'autre du diélectrique.

Pour pallier à ces réflexions, il est nécessaire d'adapter l'impédance de l'organe de liaison à celle de la source hyperfréquence ; cette adaptation s'effectue au moyen d'obstacles placés au voisinage de la discontinuité d'impédance qui cause des réflexions, c'est-à-dire au voisinage du diélectrique dans ce cas précis. La géométrie de ces obstacles et leur emplacement sont déterminées pour permettre l'adaptation à une fréquence ou dans une bande de fréquence.

Dans l'art antérieur, on connaît l'adaptation d'une fenêtre réalisée avec des transformateurs dits quart d'ondes placés de part et d'autre du diélectrique à une distance de n $\lambda$ /4 du centre du diélectrique, $\lambda$ étant la longueur d'onde à la fréquence centrale d'utilisation, et n un nombre entier (figure 1). Cette construction présente plusieurs inconvénients, dont un encombrement important ; une fabrication délicate car de nombreuses pièces doivent être assemblées avec une haute précision mécanique ; et surtout une bande passante relativement étroite, de l'ordre de quelques pour cent de la fréquence centrale pour l'exemple de la figure 1.

On connaît également dans l'art antérieur des fenêtres large bande sur guide d'onde telles que décrites dans le document F 84 00664 du 17.01.1984. Ces fenêtres sont particulièrement adaptées pour fonctionner dans une bande très large, plus d'un octave, à des niveaux de puissance élevés en onde entretenue ou en impulsions. Toutefois, cette solution ne peut être adoptée pour les fenêtres de dimensions réduites décrites par le document F 88 13342, conçues à l'origine pour l'utilisation en bande étroite.

La présente invention a pour but de procurer les avantages d'une large bande de fréquence d'utilisation sans les inconvénients de l'art connu de fenêtres classiques, ou, autrement dit, de procurer les avantages de fenêtres de dimensions réduites décrites par le document F 88 13342 dans une large bande de fréquence d'utilisation.

Pour ce faire, l'invention propose une fenêtre hyperfréquence étanche aux gaz mais transparente à l'énergie hyperfréquence, ladite fenêtre comprenant essentiellement une pastille diélectrique et un support (ou cadre) métallique sur lequel la pastille diélectrique est insérée et brasée sur la tranche de façon étanche, caractérisée en ce que l'ensemble de la fenêtre est adapté pour l'utilisation dans une large bande de fréquence, cette adaptation étant assurée par la réalisation sur le support d'une partie en forme de nervure qui, après brasage de la pastille diélectrique, se trouve plaquée, mais non brasée, contre la pastille.

Des guides d'onde du circuit d'utilisation pour la transmission de l'énergie hyperfréquence dans une large bande de fréquence sont couramment conçus avec une ou deux nervures longitudinales (aussi connues sous le nom anglais "ridge(s)") pour repousser la fréquence de coupure du guide. Ainsi selon une caractéristique importante de l'invention, deux nervures sont réalisées sur le support, et ces deux nervures se trouveront en face de deux nervures d'un guide dit en anglais "double ridge", pour adapter l'impédance de l'ensemble.

La (ou les) nervure(s) du support sera(ont) positionnée(s) indifféremment côté couplage ou côté circuit externe de transmission.

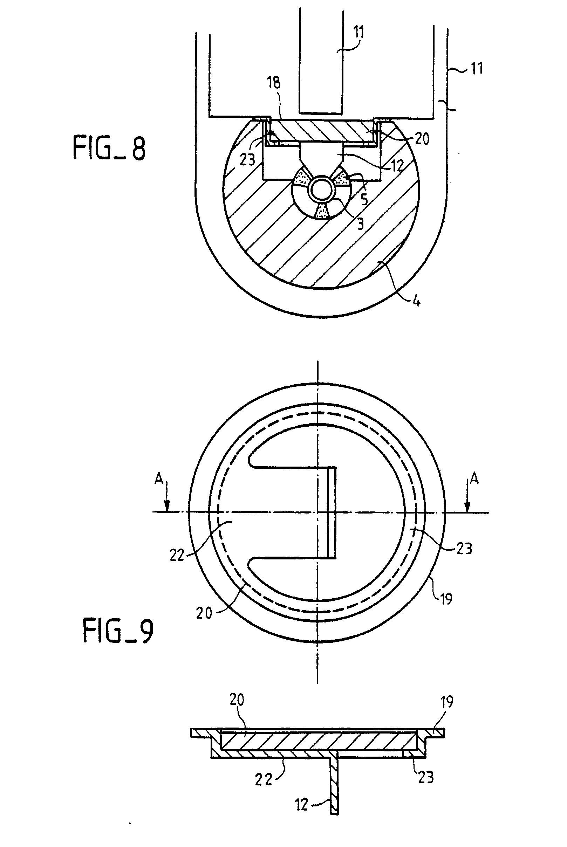

Selon une autre caractéristique de l'invention, une fenêtre selon l'invention est intégrée dans la paroi de l'enceinte à vide du tube électronique, et le couplage avec le circuit hyperfréquence est effectué par un élément de couplage découpé dans le support et plié pour venir en contact avec le circuit hyperfréquence (voir figure 8). Ce système présente les avantages de la réduction des coûts de réalisation et de montage, d'une part, et d'autre part, il limite les risques de fuite au vide aux seuls brasages de la pastille diélectrique sur son support et du support sur l'enceinte à vide, donc il permet d'augmenter le rendement de fabrication et d'améliorer la fiabilité du produit fini. Cette configuration permet de réaliser en une seule pièce : le support de la pastille diélectrique, le couplage hyperfréquence entre le circuit interne au tube et le circuit externe de transmission, ainsi que l'adaptation large bande de la fenêtre selon l'invention.

D'autres caractéristiques et avantages de la présente invention apparaîtront à la lecture de la description ci-après avec ses exemples non limitatifs de mode de réalisation et les dessins ci-annexés, dont :

- la figure 1, déjà mentionnée, montre schématiquement en coupe longitudinale et en perspective une fenêtre rectangulaire connue de l'art antérieur ;
- la figure 2, déjà mentionnée, montre schématiquement en coupe longitudinale partielle (figure 2a) et transversale (figure 2b), un tube à onde progressive muni d'une fenêtre de dimensions réduites, connue par le document F 88 13342 (11.10.1988) ;
- la figure 3 montre en plan plusieurs exemples de réalisation de fenêtre selon l'invention, avec des géométries variées :
- la figure 4 montre schématiquement, en coupe longitudinale (figure 4a) et transversale (figure 4b), un exemple de montage d'une fenêtre selon l'invention sur un tube à onde progressive à hélice, avec un guide de sortie comportant une simple nervure ou "ridge" ;
- la figure 5 montre schématiquement, en coupe longitudinale (figure 5a) et transversale (figure 5b), un exemple de montage d'une fenêtre circulaire selon l'invention sur un tube à onde progressive à hélice.
- la figure 6 montre schématiquement, en coupe longitudinale (figuré 6a) et transversale (figure 6b), un exemple de montage d'une fenêtre selon l'invention sur un tube à onde progressive à hélice, avec un guide de sortie comportant deux nervures ou "ridges" ;
- la figure figure 7 montre schématiquement, en coupe longitudinale (figure 7a) et transversale (figure 7b), un exemple de montage d'une fenêtre selon l'invention sur un tube à onde progressive à hélice, avec une sortie coaxiales de transmission externe ;
- la figure 8, déjà mentionnée, montre schématiquement en coupe transversale une caractéristique de l'invention selon laquelle une fenêtre selon l'invention est intégrée dans la paroi de l'enceinte à vide du tube électronique, et le couplage avec le circuit hyperfréquence est effectué par un élément de couplage découpé dans le support et plié pour venir en contact avec le circuit hyperfréquence ;
- la figure 9 montre en plan et en coupe transversale un exemple d'une fenêtre selon la caractéristique de l'invention montrée sur la figure 8.

Les figures représentent des exemples non limitatifs de réalisations, sur lesquelles les mêmes repères désignent les mêmes éléments ou des éléments ayant les mêmes fonctions sur les différentes figures. D'autres réalisations selon l'invention ou ses principales caractéristiques seront facilement imaginées par l'homme de l'art.

La figure 1 montre un exemple d'une fenêtre rectangulaire selon l'art antérieur. Comme indiqué sur cette figure, une pièce plane de diélectrique 91 sépare deux enceintes à pression P1 et P2, respectivement, moyennant une brasure 93 étanche aux gaz entre le bord du diélectrique 91 et les parois métalliques 94 du sous-ensemble qui est la fenêtre.

Les flèches 92 indiquent le sens de la circulation d'un liquide de refroidissement destiné à éviter la surchauffe du diélectrique lors de l'utilisation de la fenêtre.

L'exemple de la figure 1 montre aussi des moyens d'adaptation 96 introduits dans les guides rectangulaires en amont et en aval du diélectrique.

La figure 2 montre un exemple du montage d'une fenêtre de dimensions réduites, connue par le document F 88 13342, sur un tube à onde progressive.

Sur la figure 2, on a représenté la partie d'un tube à onde progressive située au niveau de la jonction entre la ligne à retard 1 du tube et un circuit externe d'extraction de l'énergie hyperfréquence du tube.

La ligne à retard 1 comporte une hélice 3 d'axe X-X[1], de cuivre par exemple, qui est maintenue au centre d'un fourreau métallique cylindrique 4 par trois tiges de support 5 isolantes décalées de 120° l'une par rapport à l'autre. Les tiges 5, qui peuvent être, par exemple, en quartz, en alumine, en glucine ou en nitrure de bore, sont brasées ou serrées sur l'hélice 3. L'extrémité du fourreau 4 située du côté de la sortie de la ligne à retard 1 (extrémité représentée sur la figure) aboute une extrémité d'un conduit 6 cylindrique qui s'étend jusqu'au collecteur (non représenté) du tube à onde progressive.

Un focalisateur est disposé concentriquement au fourreau 5 et au conduit 6. Ce focalisateur est constitué par la succession selon l'axe X-X' d'aimants permanents 7 annulaires, deux aimants voisins ayant leurs polarités inversées. Les aimants 7 sont séparés les uns des autres par des masses polaires annulaires 8.

Une ligne de transmission d'un circuit externe d'extraction de l'énergie hyperfréquence du tube à onde progressive est couplée à la ligne à retard 1. Au niveau du tube, la ligne de transmission comporte un organe de liaison 2 ayant la forme d'un guide d'onde rectangulaire à moulure. Cet organe de liaison sert à établir la jonction entre la ligne à retard 1 et un guide d'onde (non représenté) du circuit externe. L'organe de liaison 2 comporte un fond 9 et un couvercle 10, le fond ayant une section en forme de E et comprenant une base, deux ailes 21 perpendiculaires à la base et une moulure 11 équidistante des ailes 21. L'organe de liaison 2, dont l'extrémité est définie par une section droite, s'étend entre deux masses polaires 8 du focalisateur et son axe longitudinal est perpendiculaire à l'axe X-X[1] de la ligne à retard.

Le couplage hyperfréquence entre la ligne à retard 1 et l'organe de liaison 2 est réalisé au moyen d'un doigt de couplage 12 métallique ayant deux ailes planes perpendiculaires. Une aile 13, de forme trapézoïdale, est brasée à son extrémité libre à l'extrémité de l'hélice 3. L'autre aile 14, de forme sensiblement rectangulaire, est fixée au fourreau 4, dans le prolongement du fourreau, au niveau d'une encoche 15 pratiquée à l'extrémité du fourreau. L'encoche 15 dégage autour du doigt de couplage un espace vide 16 servant à l'adaptation d'impédance.

L'aile 14 du doigt de couplage 12 est fixée au fourreau de façon à être parallèle à la section droite d'extrémité de l'organe de liaison 2 et à être située en vis-à-vis de la moulure 11. Sur le mode de réalisation représenté, le fourreau 4 comporte une fente 17 pratiquée dans son épaisseur et s'étendant parallèlement à l'axe du fourreau. Cette fente a sensiblement la même épaisseur que l'aile rectangulaire 14 du doigt de couplage. L'extrémité de cette aile est enfichée dans la fente 17 et la fixation du doigt de couplage 12 au fourreau 4 est achevée par un brasage.

Le doigt de couplage 12 n'établit pas de contact mécanique entre l'hélice 3 et la moulure 11 de l'organe de liaison 2. Le couplage électromagnétique est assuré par effet capacitif ou selfique ou les deux entre la surface extérieure de l'aile rectangulaire 14 du doigt de couplage 12 et la surface d'extrémité de la moulure 11, au travers d'une fenêtre hyperfréquence 18 dont il va être question maintenant.

La fenêtre hyperfréquence 18, qui est de forme rectangulaire et s'inscrit dans la section droite de l'organe de liaison 2, comporte un support (ou cadre) 19 métallique, de ferronickel par exemple, et une plaque plane 20 réalisée dans un matériau diélectrique à faible perte, de l'alumine à très haute pureté ou du saphir, par exemple. Avantageusement la plaque 20 est fixée au support (ou cadre) 19 par un brasage sur champ. La fenêtre ainsi réalisée est perméable à l'énergie hyperfréquence et imperméable aux gaz.

La fenêtre 18 est fixée de façon étanche par son support au tube à onde progressive, entre les deux masses polaires 8 où s'étend une partie de l'organe de liaison 2. La fenêtre 18 est fixée en regard du doigt de couplage 12 de façon que sa plaque 20 soit parallèle à l'aile rectangulaire 14, c'est-à-dire aussi à la section droite d'extrémité de l'organe de liaison 2. L'interstice entre la surface intérieure de la plaque 20 et la surface, situé en vis-à-vis de l'aile rectangulaire 14 du doigt de couplage est choisi aussi étroit que possible. Il en va de même pour l'interstice séparant la surface extérieure de la plaque 20 et la section droite d'extrémité de la moulure 11. A cet effet, lorsque le support 19 est plus épais que la plaque 20, comme c'est le cas dans le mode de réalisation représenté, l'extrémité de l'organe de liaison 2 peut être configurée de façon que la moulure 11 fasse saillie sur la section droite d'extrémité de l'organe de liaison.

Pour des raisons d'adaptation d'impédance, l'extrémité du conduit tubulaire 6 est biseautée en regard de la fenêtre 18 de façon que la surface intérieure de la plaque 20 soit dégagée par rapport à l'extrémité de la ligne à retard 1.

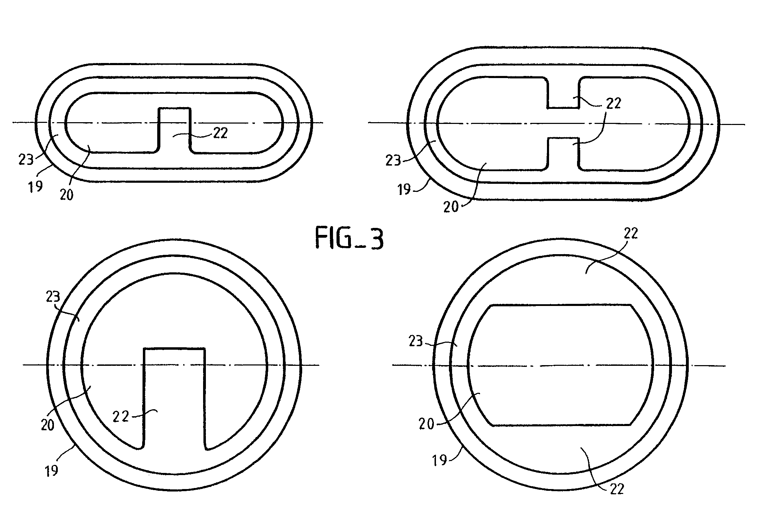

La figure 3 montre en plan plusieurs exemples de fenêtres selon l'invention ; dans chaque cas une fenêtre 18 est composée d'un support métallique 19 comportant une lèvre 23 sur son pourtour, sur lequel est fixée une pièce plane (ou plaque) diélectrique 20 ; dans chaque cas une partie du support (ou cadre) 19 fait saillie vers l'intérieur de la fenêtre plane 18, ces saillies 22 étant les moyens d'adaptation large bande de la fenêtre selon l'invention. Dans trois des quatre exemples présentés sur cette figure, ces saillies ont la forme de "nervures" qui sont disposées de façon à se trouver en face des nervures (ou "ridges") des guides de sortie hyperfréquence du circuit d'utilisation. Dans le quatrième exemple, les saillies ont une forme différente, mais la même fonction.

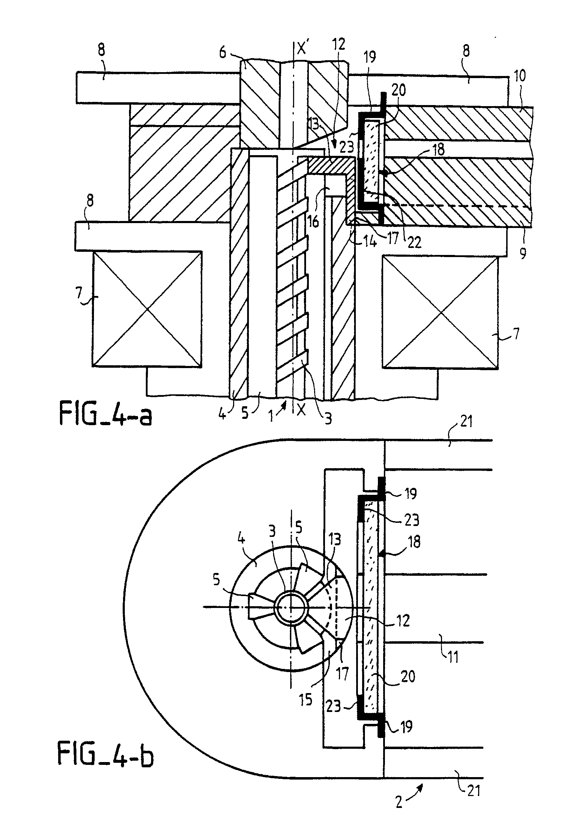

La figure 4 montre un exemple de montage d'une fenêtre oblongue selon l'invention sur un tube à onde progressive. On constate la forte ressemblance avec la figure 2, où les mêmes éléments portent les mêmes repères. La différence inventive se situe au niveau de la forme du cadre métallique 19 comportant une lèvre 23 sur son pourtour, située dans cet exemple vers l'intérieur du tube à vide, et dont une partie fait saillie vers l'intérieur de la fenêtre plane 18, cette saillie ayant avantageusement la forme de nervure ou "ridge" 22 étant le moyen d'adaptation large bande de la fenêtre selon l'invention.

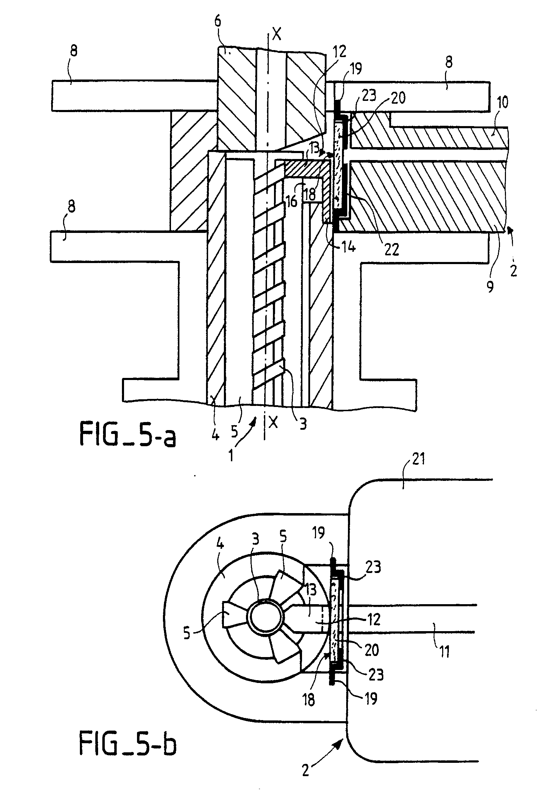

La figure 5 montre un exemple de montage d'une fenêtre circulaire selon l'invention sur un tube à onde progressive. On constate la forte ressemblance avec les figures 2 et 4, où les mêmes éléments portent les mêmes repères. Dans l'exemple d'une réalisation montrée sur la figure 5, la lèvre 23 sur le pourtour du support 19, ainsi que la saillie ou nervure 22 pour l'adaptation large bande de la fenêtre 18 se trouve de l'autre côté de la plaque diélectrique, c'est-à-dire vers l'extérieur du tube à vide ou côté circuit d'utilisation.

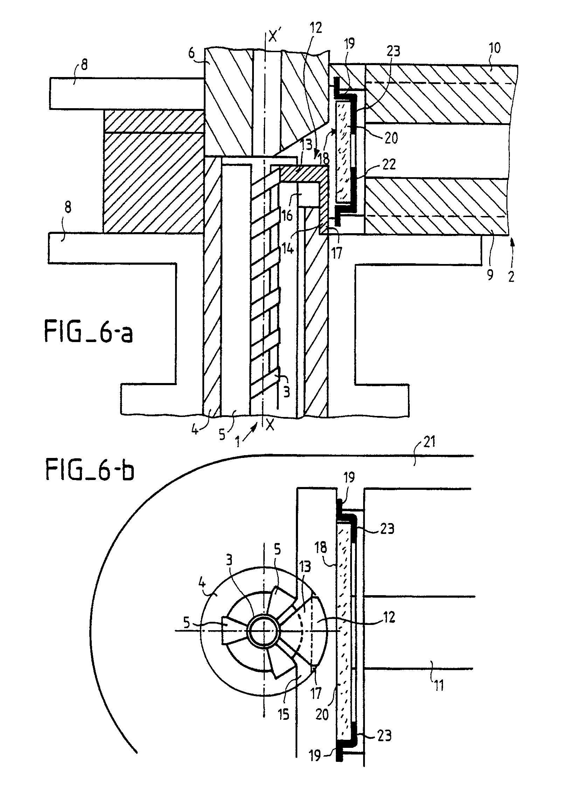

La figure 6 montre un exemple de montage d'une fenêtre à double nervure selon l'invention sur un tube à onde progressive. On constate la forte ressemblance avec les figures 2, 4 et 5, où les mêmes éléments portent les mêmes repères. La forme de la fenêtre selon l'invention est choisie parmi les exemples de la figure 3 ou d'autres formes accessibles à l'homme de l'art, en fonction du guide de sortie utilisé pour alimenter le circuit hyperfréquence d'utilisation : la lèvre 23 du cadre métallique 19 de la fenêtre 18, ainsi que la (les) saillie(s) ou nervure(s) 22 d'adaptation large bande peuvent se trouver indifféremment d'un côté ou l'autre de la plaque diélectrique 20.

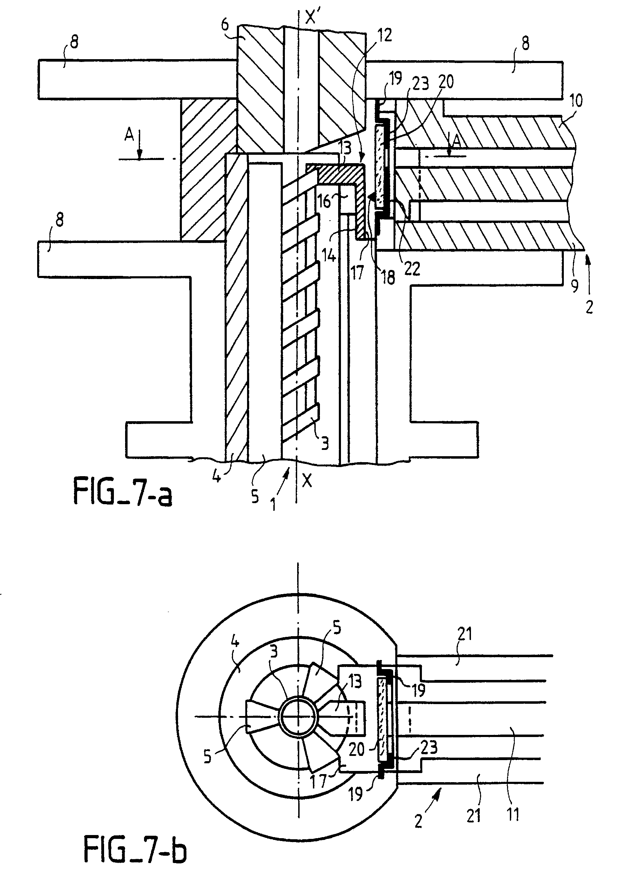

La figure 7 montre un exemple de montage d'une fenêtre selon l'invention sur un tube à onde progressive pour alimenter un circuit d'utilisation par un passage coaxial. On constate la forte ressemblance avec les figures 2, 4, 5, et 6 où les mêmes éléments portent les mêmes repères. La forme de la fenêtre selon l'invention est choisie dans cet exemple pour s'adapter en large bande pour un circuit de sortie hyperfréquence sur une ligne coaxiale.

Les figures 8 et 9 montrent une caractéristique particulière de l'invention. Sur la figure 8 est montrée une fenêtre 18 selon l'invention, intégrée au fourreau 4 d'un tube à onde progressive à hélice 3. Dans cette configuration, le doigt de couplage 12 est coupé dans le support métallique 19, comme une continuation de la saillie 22 vers l'intérieur du support qui est le moyen d'adaptation large bande selon l'invention ; cette continuation est tout simplement pliée perpendiculaire à la plane du support métallique 19 et la saillie 22 pour devenir le doigt de couplage 12 qui viendra en contact avec l'hélice 3 lors du montage.

La figure 9 montre, donc, la fenêtre 18 selon l'invention telle qu'utilisée dans le montage caractéristique de la figure 8. On y voit la forme du support métallique 19 comportant une lèvre 23 sur son pourtour, situé dans cet exemple vers l'intérieur du tube à vide, et dont une partie fait saillie vers l'intérieur de la fenêtre plane 18, cette saillie, ayant avantageusement la forme de nervure ou "ridge" 22, étant le moyen d'adaptation large bande de la fenêtre selon l'invention ; on y voit également la continuation de cette saillie 22 pliée perpendiculaire à la plane du support métallique 19 et la saillie 22 pour former le doigt de couplage 12.

On rappelle ici que le support métallique 19, comportant : une lèvre 23 pour recevoir la plaque diélectrique 20 ; la saillie 22 destinée à fournir l'adaptation large bande ; et le doigt de couplage 12 ; peut être avantageusement usiné en une seule pièce.

Ainsi l'invention permet d'obtenir simultanément les avantages d'une fenêtre hyperfréquence de dimensions réduites et une adaptation en large bande de fréquence d'utilisation.

De plus, l'encombrement, le poids, le nombre de pièces à usiner et à assembler, et le coût de réalisation sont réduits. En outre, la fiabilité d'un tube comportant une telle fenêtre est améliorée du fait que le nombre de sous-ensembles soumis aux contraintes du vide est diminué.

Selon une caractéristique importante de l'invention telle qu'illustrée sur les figures 8 et 9, ces améliorations deviennent plus importantes.

Le dispositif selon l'invention est particulièrement adapté pour l'utilisation avec un tube hyperfréquence présentant une large bande intrinsèque ; un tube à onde progressive à hélice en est un excellent exemple. Mais l'invention n'est pas limitée à cette utilisation qui est choisie à titre d'illustration non limitative.

D'autres réalisations, variantes, modifications et applications de l'invention sont à la portée de l'homme de l'art ; l'invention ne saurait être limitée aux seuls exemples présentés.

## Revendications

1. Fenêtre hyperfréquence large bande étanche aux gaz mais transparente à l'énergie hyperfréquence, ladite fenêtre 18 comprenant essentiellement une pastille plane de diélectrique 20 et un support métallique 19 sur lequel la pastille diélectrique est insérée et brasée de façon étanche, caractérisée en ce que l'ensemble de la fenêtre 18 est adaptée pour utilisation dans une large bande de fréquence, cette adaptation étant assurée par la réalisation sur le support 19 d'une partie 22 faisant saillie du support 19 vers l'intérieur de celui-ci, cette saillie ou 22 se trouvant, après brasage de la pastille diélectrique, plaquée mais non brasée, contre la pastille.

2. Fenêtre hyperfréquence selon la revendication 1, caractérisée en ce que la saillie 22 et le support métallique 19 sont usinés en une seule pièce.

3. Fenêtre hyperfréquence selon l'une quelconque des revendications 1 ou 2, caractérisée en ce que l'adaptation en large bande est assurée par la réalisation sur le support 19 de deux saillies 22 disposées symétriquement faisant saillie du support 19 vers l'intérieur de celui-ci.

4. Fenêtre hyperfréquence selon l'une quelconque des revendications 1 ou 2, caractérisée en ce que la saillie 22 est terminée à son extrémité par un "doigt de couplage" 12 ; ce doigt de couplage 12 perpendiculaire à la saillie 22, au plan du support métallique 19, et à la pastille diélectrique 20 ; ce doigt de couplage étant réalisé de façon à assurer le couplage hyperfréquence de la ligne à retard 1 d'un tube hyperfréquence vers la fenêtre 18 afin de véhiculer l'énergie hyperfréquence vers un circuit d'utilisation se trouvant de l'autre côté de la fenêtre.

5. Fenêtre hyperfréquence selon la revendication 4, caractérisée en ce que le support métallique 19, la saillie 22, et le doigt de couplage 12 sont réalisés par l'usinage d'une seule pièce.

6. Tube hyperfréquence comportant une fenêtre hyperfréquence selon l'une quelconque des revendications 1 à 5.

7. Tube à onde progressive selon la revendication 6.

8. Tube à onde progressive à ligne à retard à hélice selon la revendication 7.

# FIG_1

FIG_2-a

FIG_2-b

FIG_3

EP 0 432 047 A1

FIG_4-a

FIG_4-b

FIG_5-a

FIG_5-b

FIG_6-a

FIG_6-b

FIG_7-a

FIG_7-b

FIG_ 8

FIG_ 9

Office européen
des brevets

**RAPPORT DE RECHERCHE
EUROPEENNE**

Numéro de la demande

**EP 90 40 3473**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | US-A-3 387 237   (COOK)<br>* colonne 1, lignes 32 - 34; figure 4 * * colonne 2, ligne 47 - colonne 3, ligne 53 *<br>– – – | 1,6,7 | H 01 P 1/08<br>H 01 J 23/40<br>H 01 J 23/42 |
| A | US-A-2 932 806   (BURR)<br>* colonne 1, lignes 1 - 22; figures 1, 2 * * colonne 2, lignes 1 - 9 * * colonne 2, lignes 58 - 71; revendication 2 *<br>– – – | 1-3 | |
| A | US-A-2 972 083   (WALKER ET AL.)<br>* colonne 1, lignes 53 - 62; figures 6, 8, 9 * * colonne 3, lignes 47 - 51 *<br>– – – | 1,3 | |
| A | FR-A-1 034 327   (COMPAGNIE GENERALE DE TELEGRA-PHIE SANS FIL)<br>* page 1, colonne de gauche, lignes 18 - 25 * * page 1, colonne de droite, lignes 17 - 26 @ page 2, colonne de gauche, alinéa 9; figures 5, 6 *<br>– – – | 1,3 | |
| A | EP-A-0 274 950   (THOMSON-CSF)<br>* abrégé; figures *<br>– – – | 4,8 | |
| A | EP-A-0 189 712   (THOMSON-CSF)<br>– – – – – | | **DOMAINES TECHNIQUES RECHERCHES (Int. Cl.5)**<br><br>H 01 J<br>H 01 P |

Le présent rapport de recherche a été établi pour toutes les revendications

| Lieu de la recherche | Date d'achèvement de la recherche | Examinateur |
|---|---|---|
| La Haye | 20 février 91 | MARTIN Y VICENTE M.A |